## Europäisches Patentamt

## European Patent Office

## Office européen des brevets

(19)

(11) Veröffentlichungsnummer : **0 449 826 B1**

(12) **EUROPÄISCHE PATENTSCHRIFT**

(45) Veröffentlichungstag der Patentschrift :
27.09.95 Patentblatt 95/39

(51) Int. Cl.$^6$ : **H01L 39/24**

(21) Anmeldenummer : **89906047.9**

(22) Anmeldetag : **31.05.89**

(86) Internationale Anmeldenummer :
**PCT/DE89/00350**

(87) Internationale Veröffentlichungsnummer :
**WO 89/12914 28.12.89 Gazette 89/30**

(54) HERSTELLUNG ORIENTIERTER SCHICHTEN DES HOCHTEMPERATURSUPRALEITERS Bi-Sr- BZW. Tl-Ba-Ca-Cu-OXID.

(30) Priorität : **20.06.88 DE 3820809**
**27.09.88 DE 3832761**

(43) Veröffentlichungstag der Anmeldung :
**09.10.91 Patentblatt 91/41**

(45) Bekanntmachung des Hinweises auf die
Patenterteilung :
**27.09.95 Patentblatt 95/39**

(84) Benannte Vertragsstaaten :
**AT CH DE FR GB IT LI NL SE**

(56) Entgegenhaltungen :
**Applied Physics Letters, Band 52, Nr. 21, 23.**
**Mai 1988, Am.Inst. of Physics,(New York, US)**
**C.E. Rice et al.: "Preparation of superconduc-**
**ting thin films of calcium strontium bismuth**
**copper oxides by coevaporation" Seiten**
**1828-1830**
**Japanese Journal of Applied Physics, Band**
**27, Nr. 2, Februar 1988, Part 2, (NewYork, US),**
**N. Aizaki et al.: "YBa2Cu3Oy superconducting**
**thin film obtained by laser annealing", Seiten**
**L231-233**

(73) Patentinhaber : **SIEMENS**
**AKTIENGESELLSCHAFT**
**Wittelsbacherplatz 2**
**D-80333 München (DE)**

(72) Erfinder : **ZORN, Gerhard**
**Leutholdstr. 4**
**D-8000 München 83 (DE)**

## Beschreibung

Herstellung orientierter Schichten des Hochtemperatursupraleiters Bi-Sr- bzw. Tl-Ba-Ca-Cu-Oxid

Bekannt sind, drei Phasen eines keramischen Hochtemperatursupraleiters des Systems $Bi_2$-$Sr_2$-$Ca_{n-1}Cu_n$-Oxid mit n = 1, 2, 3 sowie mit Variationen der Stöchiometrie, insbesondere hinsichtlich des Verhältnisses Sr-Ca.

Bekannt sind aus Natur, Vol. 332, (1988), No. 6163, S. 420 bis 422 mehrere Phasen eines keramischen Hochtemperatursupraleiters des Systems $Tl_m$-$Ba_2$-$Ca_{n-1}Cu_n$-Oxid mit n = 1,2,3, 4 und m = 1 oder 2 sowie mit Variationen der Stöchiometrie, insbesondere hinsichtlich des Verhältnisses Ba-Ca.

Für die technische Verwendung supraleitender Schichten ist eine Orientierung der in den Schichten enthaltenen Kristallite nach bestimmten kristallograpnischen Richtungen von Bedeutung. Orientierte Schichten stellen in ihren physikalischen Eigenschaften einer Schritt in Richtung Einkristall dar, zeigen also z.T. die Anisotropie des entsprechenden Einkristalls, sind aber i.a. wesentlich leichter herzustellen als Einkristalle.

Bei supraleitenden Schichten aus Y-Ba-Cu-Oxid, Bi-Sr-Ca-Cu-Oxid und Tl-Ba-Ca-Cu-Oxid versucht man durch eine Orientierung bzw. Textur der Kristallite insbesondere eine hohe kritische Stromflußdichte in der Schicht zu ermöglichen.

Die Herstellung supraleitender Schichten erfolgt gemäß dem Stand der Technik nach vielen verschiedenen Verfahren, wie z.B. durch Sputtern oder Verdampfen der den Supraleiter bildenden Elemente. Dabei erhält man eine vorgegebene Kristallstruktur des Supraleiters entweder durch ein dem Aufbringen der Schicht nachfolgendes Tempern oder durch Heizen des Substrats direkt beim Aufbringen der Schicht. Die Art, in der die Elemente bei diesem Verfahren auf das Substrat aufgebracht werden, führt zu einer relativ homogenen Mischung der Elemente, so daß eine Durchmischung nicht notwendig ist, wie sie bei der Herstellung z.B. eingangs genannten keramischen Materials durch mehrmaliges Umsetzen und Mahlen erfolgt. Nach vorgenannten Verfahren der Schichtherstellung erzeugte Schichten weisen, abhängig vom Substrat und von eventuell vorhandenen Zwischenschichten (zur Vermeidung von Reaktionen zwischen Supraleiter und Substrat) nicht immer die gewünschte bzw. notwendige Textur auf.

Dicke supraleitende Schichten können z.B. durch Siebdruckverfahren unter Verwendung einer Paste aus den Rohmaterialien oder aus einem vorreagierten Pulver und einem Bindemittel hergestellt werden. Auch hier erfolgt die Herstellung der vorgegebenen Phase in einer zusammenhängenden Schicht durch nachfolgendes Tempern. Geht man hier von einer bloßen Mischung der Rohmaterialien aus, so ist es problematisch, die notwendige Homogenität der Schicht zu erreichen. Zur Verwendung eines vorreagierten Pulvers ist dagegen das bereits erwähnte mehrmalige Umsetzen und Mahlen nötig. Es liegt in der Natur dieser Herstellungsmethode des Sinterns, daß diese Dickschichten nicht texturiert sind, da nur ein Zusammenbacken der statistisch orientierten Kristallite beim Sintern erfolgt.

Weiterer Stand der Technik enthält die Druckschrift Jap. Jour. of Appl. Phys. Vol 27 (1988) Part 2, S.L. 231, in der das nach der Herstellung einer $YBa_2Cu O_y$-Schicht vorzunehmende Tempern bei 400°C beschrieben ist, um die Schicht in eine solche mit supraleitender Eigenschaft umzuwandeln.

Es wird dazu Laserstrahlung benutzt und es ist in diesem Zusammenhang auch das Wort "schmelzen" angegeben, wobei das Substrat auf einer Temperatur von 400°C gehalten wird.

Aufgabe der vorliegenden Erfindung ist, die Herstellungsbedingung für Schichten mit wie oben angegebenen Zusammensetzungen supraleitenden Materials anzugeben, wobei diese Schichten reproduzierbar vorgegebene Textur und Struktur haben.

Diese Aufgabe wird mit den Maßnahmen des Patentanspruchs 1 gelöst.

Der Erfindung lagen unter anderem folgende Erkenntnisse zugrunde. Mit Hilfe der Hochtemperatur-Röntgenbeugung konnte die erfindungsgemäße Feststellung gemacht werden, daß unter bestimmten, noch zu erörternden Umständen Wismut-Strontium- bzw. Tallium 1 oder 2-Barium-Kalzium-Kupfer-Oixd direkt aus den Rohmaterialien in nur einem Arbeitsgang als bereits praktisch perfekt orientierte Schicht hergestellt werden kann. Dabei ist ein erfindungsgemäßes Aufschmelzen der in der Rohstoffmischung der bereits aufgebrachten Schicht enthaltenen Materialien von wesentlicher Bedeutung. In dem erfindungsgemäß vorgesehenen schmelzflüssigen Zustand findet der Stofftransport der Rohmaterialien wesentlich schneller statt, als beispielsweise beim Umsetzen des keramischen Materials. Mit der Erfindung erreicht man somit eine optimale Durchmischung der Rohmaterial-Bestandteile bzw. -elemente schon nach sehr kurzer Zeit, typischerweise bereits in Sekunden bis Minuten.

Aus der erfindungsgemäß vorgesehenen Schmelze kristallisieren bei Temperaturen im Bereich der Kristallisationstemperatur plättchenförmige Kristallite der jeweils vorgegebenen supraleitenden Phase. Wie die mittels der Röntgenbeugung vorgenommene Beobachtung des Kristallisationsvorganges ergab, "schwimmen" diese bereits gebildeten einkristallinen Plättchen mit ihrer kristallographischen c-Achse senkrecht zur Oberfläche des Substrats bzw. der Schmelze ausgerichtet in der noch vorhandenen Schmelze. Dieses Verhalten wurde sogar bei einem solchen Substrat aus Zirkonoxid festgestellt, das keine besondere Oberflächenbehandlung erfahren hatte.

Beim dann weiterem Abkühlen bleibt diese erfindungsgemäß erreichte perfekte Orientierung der wachsenden Kristallite (001-Textur) erhalten, wie dies festgestellt werden konnte.

Von Bedeutung für ein Ausbleiben einer Veränderung der ursprünglichen Einwaage bzw. Stöchiometrie, und zwar insbesondere im Zeitraum, in dem die Kristallisation aus der Schmelze abläuft, ist die Vermeidung von Reaktionen der Schmelze mit dem Material des Substrats. Diese Bedingung läßt sich hinreichend erfüllen, wenn die Bedingungen des erfindungsgemäß vorgesehenen Verfahrensschrittes des vorübergehenden Erreichens des Schmelzzustandes für nur kurze Zeit aufrechterhalten werden. Probleme ergeben sich damit nicht, denn, wie schon oben gezeigt, erfolgt die Homogenisierung im schmelzflüssigen Zustand innerhalb kürzester Zeit.

Nachfolgend wird ein Ausführungsbeispiel zur Erfindung mit seinen Varianten beschrieben. Dieses Verfahren umfaßt die folgenden Verfahrensschritte:

1. Eine einer vorgegebenen Stöchiometrie entsprechende Mischung, und zwar entweder der Rohmaterialien oder der Bestandteilselemente, wird auf ein zur Beschichtung vorgesehenes Substrat aufgebracht. Dies erfolgt z.B. durch Siebdrucken oder durch Aufschlämmen der Karbonate, Oxyde und dgl.. Für das Aufbringen kann auch von vorreagiertem Pulver ausgegangen werden. Für dünne Schichten wendet man zweckmäßigerweise Sputtern oder Verdampfen der Bestandteile bzw. Elemente an.

2. Das Substrat wird auf Kristallisationstemperaturen d. h. bis auf Temperaturen eines Temperaturbereiches der Kristallisation der vorgegebenen Phase aufgeheizt. Das Aufheizen kann z.B. nach dem Stand der Technik mittels Beheizung erfolgen oder es kann auch Energie-, insbesondere Laser-Bestrahlung hierfür vorgesehen sein. Bei Bi-Sr-Ca-Cu-Oxid liegen solche Temperaturen je nach der gewünschten Phase bzw. Struktur in einem Temperaturbereich $T_1$, der vorzugsweise zwischen 860 und 910° C liegt. Es ist dies der Hauptbereich des bekannten und zu einem Anteil des auch bei der Erfindung vorgesehenen Kristallisationsprozesses.

3. Als erfindungsgemäßer Schritt wird mittels eines Lichtblitzes (rapid optical annealing), mittels Anwendung von Laserstrahlung, mittels wie bei dem oben angegebenem indirekten Heizen des Materials der Schicht oder dgl., diese Schicht weiter bzw. zusätzlich auf Temperaturen oberhalb der Schmelztemperatur $T_S$ aufgeheizt. Bei dieser erfindungsgemäßen Maßnahme kann gemäß einer Variante die Schmelztemperatur des Materials der Schicht sogar für beschränkte Zeit wesentlich ($T_{max}$) überschritten werden. An sich kann dieses erfindungsgemäß vorgesehene zusätzliche Aufheizen auch langzeitig z.B. länger als für Sekunden bzw. Minuten ausgeführt werden, (vor allem von Bedeutung bei indirektem Heizen) nämlich dann, wenn eine Reaktion der Schmelze mit dem Substrat ausgeschlossen ist. Man wird möglichst kurzzeitiges weiteres bzw. zusätzliches Aufheizen bevorzugen.

Dieses gegenüber dem Stand der Technik vorgesehene weitere zusätzliche Aufheizen kann auch Bestandteil, d.h. die Endphase, eines einheitlichen Aufheizvorganges sein, der dann, abweichend vom Stand der Technik, erfindungsgemäß bis zur Schmelztemperatur $T_S$ der Schicht oder noch etwas höher geführt wird.

4. Nach diesem gegenüber dem Stand der Technik zusätzlichen Aufheizen läßt man das Substrat auf die in Punkt 2 angegebene Kristallisationstemperatur abkühlen. Es kann von wesentlichem Vorteil sein, eine Haltezeit von 0,5 bis 3 min bei Erreichen der oberen Kristallisationstemperatur einzuhalten. Entsprechend üblichem Kristallwachsen ist unter Kristallisationstemperatur ein Temperaturbereich $T_1$ zu verstehen, in dem einerseits bereits Kristallisation erfolgt, andererseits aber die Temperatur noch hoch genug ist, daß sauberes Kristallwachstum abläuft.

Der an sich nach dem Stand der Technik ablaufende Verfahrensschritt dieses Punktes 4 unterscheidet sich aber erfindungsgemäß in den Details des Kristallwachstums. Erfindungsgemäß geht hier das Kristallwachstum von im Verfahrensschritt 3 erzeugten zahlreichen, bereits perfekt orientierten Keimkristallen aus, so daß das insgesamte Kristallwachstum hohe Perfektion der Ausrichtung aufweist. Dies bei der Erfindung selbst dann, wenn im Verfahrensschritt des Punktes 4 weniger sorgfältig gearbeitet werden sollte, als dies für Verfahren nach dem Stand der Technik üblich und vorgeschrieben ist.

5. Vorzugsweise nach kurzer Haltezeit im Bereich der Kristallisationstemperaturen $T_1$ wird das Substrat mit der entsprechend der Erfindung hochqualitativen Kristallorientierung auf Raumtemperatur abgekühlt.

Die Erfindung läßt sich insbesondere auch dazu verwenden, in der Schicht aus dem an sich supraleitenden Material Leiterbahnen mit der erfindungsgemäß optimalen Kristallorientierung zu erzeugen. Diese Leiterbahnen haben dann die eigentliche supraleitende Eigenschaft. Die Leiterbahnen werden z.B. in der Weise hergestellt, daß nur in den diesen Leiterbahnen entsprechenden Flächenanteilen der Schicht die erfindungsgemäß zu erzielende optimale Kristallorientierung erreicht ist, nämlich indem man die Schicht nur in diesen Flächenanteilen mit dem zusätzlichen Aufheizen beaufschlagt. Vorteilhafter ist es aber, das Aufheizen gemäß den Verfahrensschritten 2 und 3 auf die Flächenanteile der Leiterbahnen zu begrenzen. Damit entstehen ebenfalls die supraleitenden Bahnen mit optimaler Kristallorientierung. Zusätzlich bietet sich hier aber die Möglichkeit, restliche, für die Leiterbahnen und dgl. nicht benötigte Anteile der Schicht, z.B. durch Abwaschen, wieder zu entfernen.

Weitere Erläuterungen gehen aus den nachfolgend beschriebenen Figuren hervor.

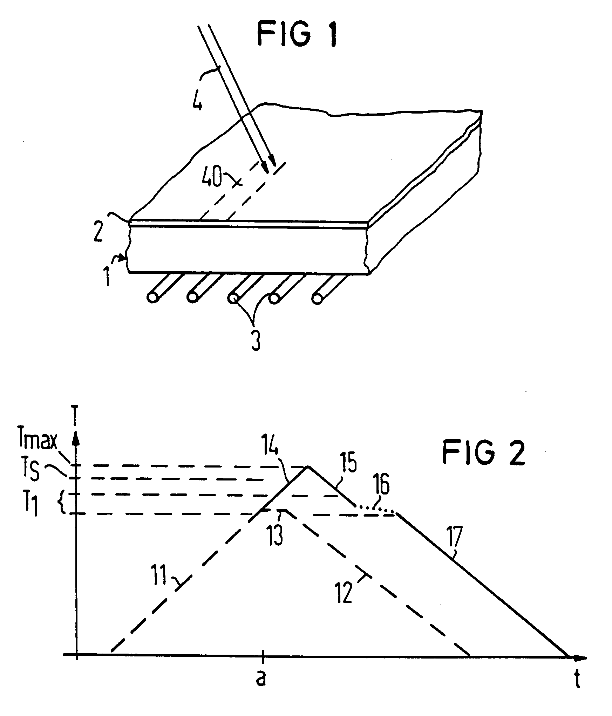

Die Figur 1 zeigt in einer perspektivischen Ansicht mit 1 bezeichnet ein Substrat, auf dem sich eine Schicht 2 aus dem Wismut-Strontium-Kalzium-Kupfer-Oxid befindet. Mit 3 ist eine Heizung für das Substrat 1 bezeichnet. Gemäß einer Ausführungsform der Erfindung wird mittels dieser Heizung 3 die Schicht 2 auf Temperaturen des mit TI bezeichneten Temperaturbereichs aufgeheizt, wobei diese Temperaturen im Temperaturbereich $T_1$ der Kristallisation des Materials der Schicht 2 liegen. Mit 4 ist dann Strahlung von Lichtblitzen oder eines Lasers bezeichnet. Diese Strahlung 4 dient zum erfindungsgemäßen zusätzlichen weiteren Aufheizen auf Temperaturen, die wenigstens den Schmelzpunkt $T_S$ erreichen, insbesondere aber übersteigen. Mit 40 ist ein gemäß der obenerwähnten Anwendung erzeugtes Leiterbahnstück in der Schicht 2 bezeichnet.

Gemäß einer anderen Ausführungsform der Erfindung kann das Aufheizen wenigstens im wesentlichen auch allein durch die Energiestrahlung 4 erfolgen.

Figur 2 zeigt ein Temperatur-(T)-Zeit-(t)-Diagramm. Die gestrichelt eingetragenen Kurvenzüge 11 und 12 sind Aufheizung und Abkühlung nach dem Stand der Technik mit 13 ist die Kristallisation nach dem Stand der Technik bezeichnet. Die Kristallisation erfolgt in dem mit $T_1$ bezeichneten Temperaturbereich.

Mit der ausgezogenen Kurve 14 ist auf die erfindungsgemäß vorgesehene zusätzliche Aufheizung auf dem Stand der Technik gegenüber höhere Temperaturen bis wenigstens zum Schmelzpunkt $T_S$ oder bis zu noch höhereren Temperaturen $T_{max}$ oberhalb des Schmelzpunktes hingewiesen. Das Aufheizen gemäß den Anteilen 11 und 14 kann auch erfindungsgemäß ein einziger durchlaufender Aufheizprozeß, z.B. allein mittels Laserstrahlung, sein.

Mit 15 ist der Temperaturabfall von der Temperatur $T_{max}$ bzw. der Temperatur $T_S$ bis in den Bereich der Temperaturen $T_1$ bezeichnet. Während dieses Temperaturabfalls erfolgt das erfindungsgemäße erste Auskristallisieren mit der der Erfindung gemäßen Orientierung der gerade gebildeten Kristallite in der ansonsten noch im wesentlichen schmelzflüssigen Schicht 2. Der als Weiterbildung der Erfindung vorgesehene flache Temperaturabfall 16 im Bereich der Kristallisationstemperaturen $T_1$ begünstigt das vollständige Auskristallisieren der dann erfindungsgemäß optimal kristallorientierten Schicht 2. Mit 17 ist der Abkühlungsprozeß bezeichnet, der der bekannten Abkühlung 12 entspricht.

Wie aus der Figur 2 ersichtlich, setzt die Erfindung beim Zeitpunkt t = a ein, nämlich wo erfindungsgemäß entgegen der Praxis des Standes der Technik noch weiteres Aufheizen bis zum Schmelzpunkt $T_S$ oder vorzugsweise bis über den Schmelzpunkt durchgeführt wird.

**Patentansprüche**

1. Verfahren zur Herstellung von Kristall-orientierten supraleitenden Schichten aus Hochtemperatur-Supraleitermaterial des Systems

$$(X) - Ca_{n-1}Cu_nO_y$$

mit     $(X) = Bi_2Sr_2$ und n = 1, 2, 3 oder
mit     $(X) = Tl_mBa_2$ und n = 1, 2, 3, 4 und m = 1 oder 2

und sich davon geringfügig unterscheidender Stöchiometrie, wobei zunächst auf einem Substrat (1) im Ergebnis eine Schicht aus diesem vorgegebenen Material erzeugt wird und diese Schicht (2) auf eine Temperatur innerhalb desjenigen Temperaturbereiches (T1) aufgeheizt wird, innerhalb dessen die vorgegebene Phase kristallisiert, wobei dann zumindest Anteile (40) dieser Schicht (2) zusätzlich in die Schmelzphase gebracht werden, und schließlich die Schicht wieder abgekühlt wird,
**gekennzeichnet dadurch,**
daß diese Schicht (2) während des Abkühlens bevor sie auf Raumtemperatur abgekühlt wird bis zur erfolgreichen Kristallisation der Schicht auf einer Temperatur innerhalb des Temperaturbereiches (T1) gehalten wird.

2. Verfahren nach Anspruch 1,
**gekennzeichnet dadurch,**
daß das Aufheizen bis in die Schmelzphase ein einziger durchlaufender Aufheizprozeß ist.

3. Verfahren nach Anspruch 1 oder 2,
**gekennzeichnet dadurch,**
daß die Schmelzphase mittels Aufheizen durch Lichtblitze (4) erreicht wird.

4. Verfahren nach Anspruch 1 oder 2,
**gekennzeichnet dadurch,**
daß die Schmelzphase mittels Aufheizen durch Laserstrahlung (4) erreicht wird.

5. Verfahren nach Anspruch 1 oder 2,
**gekennzeichnet dadurch,**
daß die Schmelzphase mittels Aufheizen durch indirekte Heizwärme (3) erreicht wird.

6. Verfahren nach einem der Ansprüche 1 bis 5,
**gekennzeichnet dadurch,**

daß nach dem Widerabkühlen dieser zusätzlichen Aufheizung in die Schmelzphase eine Haltezeit (16) von 0,5 bis 3 min für das Kristallisieren der Schicht eingelegt wird.

## Claims

1. Method of producing crystal-oriented superconducting layers of high-temperature superconductor material of the system

$$(X) - Ca_{n-1}Cu_nO_y$$

with    $(X) = Bi_2Sr_2$ and n = 1, 2, 3 or
with    $(X) = Tl_mBa_2$ and n = 1, 2, 3, 4 and m = 1 or 2

and stoichiometry differing slightly therefrom, a layer of said specified material first being created in effect on a substrate (1) and said layer (2) being heated to a temperature within that temperature range $(T_1)$ within which the specified phase crystallizes, at least components (40) of said layer (2) then being converted additionally to the molten phase and the layer finally being cooled again, characterized in that, during cooling, said layer (2) is held, before it is cooled to room temperature, at a temperature within the temperature range $(T_1)$ until the layer has successfully crystallized.

2. Method according to Claim 1, characterized in that the heating to the molten phase is a single, continuous heating process.

3. Method according to Claim 1 or 2, characterized in that the molten phase is reached by means of heating with pulses of light (4).

4. Method according to Claim 1 or 2, characterized in that the molten phase is reached by means of heating with laser radiation (4).

5. Method according to Claim 1 or 2, characterized in that the molten phase is reached by means of heating with indirect calorific heat (3).

6. Method according to one of Claims 1 to 5, characterized in that, after the re-cooling of said additional heating to the molten phase, a holding time (16) of 0.5 to 3 min is inserted for the purpose of crystallizing the layer.

## Revendications

1. Procédé de fabrication de couches supraconductrices à orientation cristalline en une matière supraconductrice à haute température du système

$$(X) - Ca_{n-1}Cu_nO_y$$

avec    $(X) = Bi_2Sr_2$ et n = 1, 2, 3 ou
avec    $(X) = Tl_mBa_2$ et n = 1, 2, 3, 4 et m = 1 ou 2

et de stoechiométrie en différant légèrement, qui consiste à produire d'abord sur un substrat (1) en résultat une couche en cette matière donnée à l'avance et à porter cette couche (2) à une température comprise dans l'intervalle (T1) de température dans lequel la phase donnée à l'avance cristallise, au moins des parties (40) de cette couche (2) étant mises ensuite en plus en phase fondue et la couche étant enfin refroidie à nouveau, caractérisé en ce qu'il consiste en maintenir cette couche (2) pendant le refroidissement avant qu'elle ne soit refroidie à la température ambiante jusqu'à cristallisation réussie de la couche à une température comprise dans l'intervalle de température (T1).

2. Procédé suivant la revendication 1, caractérisé en ce que le chauffage est un processus de chauffage unique et continu jusqu'à obtention de la phase fondue.

3. Procédé suivant la revendication 1 ou 2, caractérisé en qu'il consiste à obtenir la phase fondue au moyen d'un chauffage par éclairs lumineux (4).

4. Procédé suivant la revendication 1 ou 2, caractérisé en qu'il consiste à obtenir la phase fondue par chauffage par rayonnement laser (4)

5. Procédé suivant la revendication 1 ou 2, caractérisé en qu'il consiste à obtenir la phase fondue par chauffage par de la chaleur (3) de chauffage indirecte.

6. Procédé suivant la revendication 1 ou 5, caractérisé en qu'il consiste après le refroidissement faisant suite à ce chauffage supplémentaire amenant à la phase fondue à intercaler un temps de maintien (16) de 0,5 à 3 minutes pour la cristallisation de la couche.

## FIG 1

## FIG 2